# EUROPEAN PATENT APPLICATION

(11) **EP 4 749 359 A1**
(43) Date of publication of application: **27.05.2026**
(21) Application number: 25215235.0
(22) Date of filing: 12.11.2025
(51) Int. Cl.: G02F 1/21, G02F 1/01, G02B 6/293, H01S 3/105, H01S 3/106, H01S 5/14, G02F 1/225

(54) **REFLECTOR WITH TUNABLE SPECTRAL REFLECTANCE**

(30) Priority: 26.11.2024 US 202463725487 P; 28.10.2025 US 202519371005
(71) Applicant: Marvell Asia Pte Ltd, Singapore 369522 (SG)
(72) Inventor: He, Xiaoguang, Diamond Bar, CA, 91765 (US); Kato, Masaki, Palo Alto, CA, 94303 (US); Nagarajan, Radhakrishman, 369522 Singapore (SG)
(74) Representative: Grünecker Patent- und Rechtsanwälte PartG mbB

(57) **Abstract**

An optical device for enabling more flexible and precise control of spectral reflectance in a selected wavelength range having a maximal wavelength (λₘₐₓ) and a minimal wavelength (λₘᵢₙ). The device includes a first Mach-Zehnder interferometer (MZI), including first and second legs having a tunable first optical pathlength difference (OPD) greater than 2×λₘₐₓ, and a second MZI, coupled in series with the first MZI and including third and fourth legs having a tunable second OPD less than 2×λₘᵢₙ. An optical coupler is configured to direct an input optical signal in the selected wavelength range into the first and second MZIs and to output a reflected optical signal from the first and second MZIs. A controller is configured to adjust the first and second tunable OPDs to control the spectral reflectance of the reflected output optical signal.

## Description

### CROSS-REFERENCE TO RELATED APPLICATION

This application claims the benefit of U.S. Provisional Patent Application 63/725,487, filed November 26, 2024, which is incorporated herein by reference.

### FIELD OF THE INVENTION

The present invention relates generally to optoelectronic devices, and particularly to reflectors with tunable spectral reflectance.

### BACKGROUND

Optoelectronic devices, such as semiconductor lasers, are used in multiple applications, such as illumination, communication and metrology, in which the wavelength spectrum of the optical radiation emitted by these devices may need to be controlled. Such spectral control may be achieved by using, for example, optical filters or mirrors with tunable spectral reflectance. The tuning of the spectral reflectance can include adjusting any or all of the peak reflectance, center wavelength, and bandwidth of the reflectance band. A mirror with adjustable spectral reflectance is also referred to herein as a tunable reflector.

Mach-Zehnder interferometers (MZIs) are used in a variety of silicon photonics applications. For example, El Shamy et al. describe a tunable filter based on an MZI in "Modelling, characterization, and applications of silicon on insulator loop terminated asymmetric Mach Zehnder interferometer," Scientific Reports 12:3598 (2022). The authors describe a loop-terminated MZI whose spectrum can be tuned not only by controlling the phase difference between the interferometer arms, but also by using its directional coupler coefficients, forming a spectral tunable filter.

### SUMMARY

Embodiments of the present invention that are described hereinbelow provide improved designs for reflectors with a tunable spectral reflectance, as well optoelectronic devices using such reflectors and methods for tuning such reflectors.

There is therefore provided, in accordance with an embodiment of the invention an optical device for enabling more flexible and precise control of spectral reflectance in a selected wavelength range having a maximal wavelength (lmax) and a minimal wavelength (l-min). The device includes a first Mach-Zehnder interferometer (MZI), including first and second legs having a tunable first optical pathlength difference (OPD) greater than 2× lmax, and a second MZI, coupled in series with the first MZI and including third and fourth legs having a tunable second OPD less than 2× lmin. An optical coupler is configured to direct an input optical signal in the selected wavelength range into the first and second MZIs and to output a reflected optical signal from the first and second MZIs. A controller is configured to adjust the first and second tunable OPDs to control the spectral reflectance of the reflected output optical signal.

In a disclosed embodiment, the first, second, third and fourth legs include waveguides. The waveguides and optical couplers may be disposed on a silicon photonic integrated circuit (PIC).

In some embodiments, the first and second MZIs include respective heaters, and the controller is coupled to drive the respective heaters to adjust the first and second OPDs.

Additionally or alternatively, the optical device includes a termination loop coupled in series with the first and second MZIs.

In some embodiments, the controller is configured to tune the first OPD to select a peak wavelength of the spectral reflectance and to tune the second OPD to adjust a curve shape of the spectral reflectance.

In a disclosed embodiment, the optical coupler includes a first optical coupler at a first end of the first MZI to split the input optical signal between the first and second legs and to output the reflected optical signal from the first MZI, and the optical device further includes a second optical coupler to couple an input end of the second MZI to a second end of the first MZI, opposite the first end.

There is also provided, in accordance with an embodiment of the invention, an optoelectronic device for enabling more flexible and precise control of spectral properties of laser radiation. The device includes a gain medium and configured to amplify the laser radiation within a gain band between a maximal wavelength (lmax) and a minimal wavelength (lmin). A laser cavity contains the gain medium and includes a first reflector disposed on a first side of the gain medium and a second reflector disposed on a second side of the gain medium, opposite the first side. The second reflector includes a first Mach-Zehnder interferometer (MZI), including first and second legs having a tunable first optical pathlength difference (OPD) greater than 2× lmax, and a second MZI, coupled in series with the first MZI and including third and fourth legs having a tunable second OPD less than 2× lmin. An optical coupler is configured to direct an input optical signal in the selected wavelength range into the first and second MZIs and to output a reflected optical signal from the first and second MZIs. A controller is configured to adjust the first and second OPDs to adjust the spectral properties of the laser radiation by controlling a spectral reflectance of the reflected output optical signal from the second reflector relative to the input optical signal.

In a disclosed embodiment, the controller is configured to adjust the first and second OPDs so as to reduce a reflectance of the second reflector at a peak of the gain band, thereby broadening a spectrum of the laser radiation emitted from the gain medium through the second reflector.

There is additionally provided, in accordance with an embodiment of the invention, a method for flexible and precise control of spectral reflectance in a selected wavelength range having a maximal wavelength (lmax) and a minimal wavelength (lmin). The method includes coupling a first Mach-Zehnder interferometer (MZI), including first and second legs and having a tunable first optical pathlength difference (OPD) between the first and second legs that is greater than 2× lmax, in series with a second MZI, including third and fourth legs having a tunable second OPD less than 2× lmin. An input optical signal in the selected wavelength range is directed into the first and second MZIs. A reflected optical signal is output from the first and second MZIs. The first and second OPDs are adjusted to control the spectral reflectance of the reflected optical signal.

The present invention will be more fully understood from the following detailed description of the embodiments thereof, taken together with the drawings in which:

### BRIEF DESCRIPTION OF THE DRAWINGS

Fig. 1 is a block diagram that schematically illustrates a laser device, in accordance with an embodiment of the invention;
Fig. 2 is a schematic plot of the spectral reflectance of an MZI in the laser device of Fig. 1 at varying temperatures, in accordance with an embodiment of the invention;
Fig. 3 is a schematic plot of the spectral reflectance of a second MZI in the laser device of Fig. 1 at varying temperatures, in accordance with an embodiment of the invention; and
Fig. 4 is a schematic plot of spectral gain compensation of the laser device of Fig. 1, in accordance with an embodiment of the invention.

### DETAILED DESCRIPTION OF EMBODIMENTS

### OVERVIEW

U.S. Patent Application Publication 2025/0096530, whose disclosure is incorporated herein by reference, describes an optoelectronic device that includes a gain medium having first and second ends, wherein the gain medium is configured to amplify laser radiation within a gain band having a peak at a given wavelength. A laser cavity, containing the gain medium, includes a first reflector disposed on a first side of the gain medium and a second reflector disposed on a second side of the gain medium, opposite the first side. The second reflector has a reflectance as a function of wavelength that is tunable so as to reduce a reflectance of the second reflector at the peak of the gain band, thereby broadening a spectrum of the laser radiation emitted from the gain medium through the second reflector.

To control the spectral emission characteristics of the device, the second reflector comprises a tunable Mach-Zehnder interferometer (MZI). In this reflector, the optical pathlength difference (OPD) between the legs of the MZI and the coupling coefficient of a directional coupler joining the legs are adjusted by respective heaters. This design enables effective flattening of the laser gain curve, but adjustment of the reflectance parameters requires careful tweaking and control of the heater settings and can be sensitive to variations in the fabrication process and operating environment.

Embodiments of the present invention are directed to enabling more flexible and precise control of spectral reflectance. The term "spectral reflectance," as used in the present description and in the claims, is defined as the relationship between the amplitude of the reflected optical signal to the amplitude of the input optical signal as a function of wavelength. The terms "light" and "optical radiation" are used synonymously in the present description and in the claims to refer to electromagnetic radiation in any of the infrared, visible, and ultraviolet spectral ranges.

Thus, the disclosed embodiments provide a tunable reflector comprising a pair of MZIs, arranged in series, to enable more flexible and precise control of spectral reflectance. The reflector is designed to operate in a selected wavelength range between wavelengths lmin and lmax. When the reflector is used in a laser, this range typically contains the peak wavelength of the gain band of the laser gain medium. Each of the two MZIs comprises a pair of legs whose OPD may be tuned by heating one or both of the legs of the MZI. A first optical coupler splits an input optical signal between the two legs of one MZI and outputs a reflected optical signal from the MZI, while a second optical coupler couples the two MZIs together in series.

To enable flexible tuning of the spectral reflectance, the OPD of one of the two MZIs is greater than 2× lmax, while that of the other MZI is less than 2× lmin. At least one leg of each MZI has an adjacent thermal heater. A controller tunes the respective OPDs of the two MZIs by adjusting the respective temperatures of the heaters. By appropriate choices of the OPDs, the controller is able to tune not only the peak wavelength and peak amplitude of the reflectance spectrum, but also the spectral width of the reflectance spectrum. When used in a laser, these spectral characteristics can be controlled to create a wide, flat gain band, which is conducive to generating a comb of multiple wavelength sub-bands in the laser output.

### SYSTEM DESCRIPTION

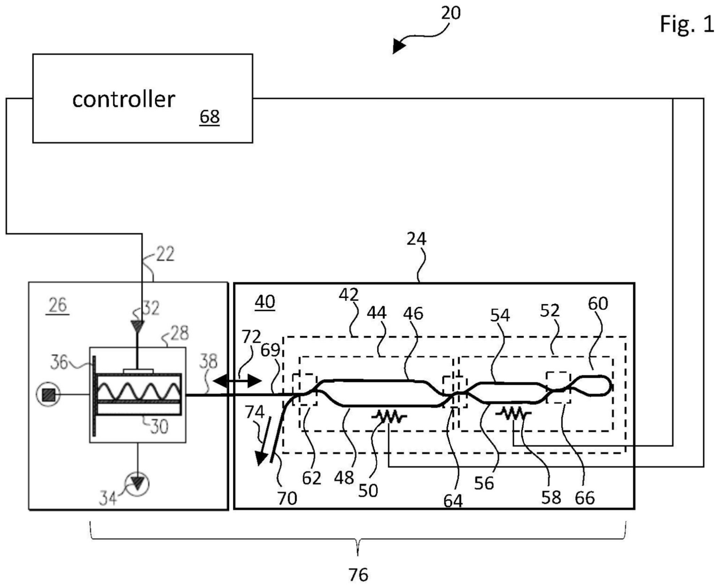

Fig. 1 is a block diagram that schematically illustrates a laser device 20, in accordance with an embodiment of the invention. Device 20 comprises an active optical chip 22 on a III-V semiconductor substrate 26, such as GaAs or InP, and a photonic integrated circuit (PIC) 24 on an optical substrate 40, for example a silicon-on-insulator (SOI) substrate. For mechanical stability and compact packaging, chip 22 may be bonded to optical substrate 40, for example using a suitable adhesive. Alternatively, chip 22 and PIC 24 may be mounted separately and connected, for example, by a suitable optical fiber.

Chip 22 comprises a reflective semiconductor optical amplifier (RSOA) 28, comprising an optical gain medium 30, which amplifies laser radiation within a certain gain band, and a reflector 36 formed at the inner end of gain medium 30. Application of a drive voltage between electrodes 32 and 34 on chip 22 gives rise to optical gain in medium 30 across the gain band, for example over a band of several tens of nanometers between wavelengths lmin and lmax, centered at a peak at around 1310 nm or 1550 nm depending on the type of gain medium that is used. Gain medium 30 may comprise, for example, GaInAsP, AlGaInAs quantum wells, or InAs quantum dots, which emit light in these gain bands. Reflector 36 may comprise a distributed Bragg reflector (DBR), for example, or a reflective coating on the rear facet of the RSOA. A waveguide 38 on substrate 26 conveys laser radiation into and out of the RSOA at the end opposite reflector 36.

PIC 24 comprises a tunable reflector 42 (a reflector with a tunable spectral reflectance), which is optically coupled to waveguide 38 and completes a laser cavity for RSOA 28. Tunable reflector 42 comprises a first MZI 44, comprising waveguide legs 46 and 48 and a heater 50, and a second MZI 52, comprising waveguide legs 54 and 56 and a heater 58. The OPD between legs 46 and 48 in MZI 44 is greater than 2× lmax, while the OPD between legs 54 and 56 of MZI 52 is less than 2× lmin. Although the embodiment shown in Fig. 1 has a single heater for each of MZI 44 and 52, in alternative embodiments each MZI may comprise, for example, a pair of heaters adjacent to and on opposite sides of a single leg of the MZI or pairs of heaters adjacent to each leg of a given MZI. Tunable reflector 42 further comprises a termination loop 60, functioning as a broadband reflector, and optical couplers 62, 64 and 66.

Optical coupler 62 receives an input optical signal from waveguide 38 via a waveguide 69 and splits it between legs 46 and 48. Depending on the settings of heaters 50 and 58, optical coupler 62 returns a part of the signal reflected by tunable reflector 42 into waveguide 38 and outputs another part of the reflected signal into an output waveguide 70. The optical signal propagating within a laser cavity 76 defined by RSOA 28 and tunable reflector 42 is denoted by an arrow 72, and the optical signal output from waveguide 70 is denoted by an arrow 74. Optical coupler 64 couples MZI 44 to the input end of MZI 52, and optical coupler 66 couples the output end of MZI 52 to loop 60. Optical couplers 62, 64, and 66 may comprise directional waveguide couplers, for example, as are known in the art. Alternatively, the order of the first and second MZIs may be reversed, with MZI 52 receiving the input optical signal from optical coupler 62 at its first end and coupled at its second end by optical coupler 64 to MZI 44.

A controller 68 tunes the OPDs of MZI 44 and MZI 52 by driving respective heaters 50 and 58, thus changing the temperature of respective legs 48 and 56. This tuning of the OPDs in turn tunes the spectral reflectance of tunable reflector 42, as is further detailed hereinbelow.

Alternatively, tunable reflectors of the sort described herein may be used to adjust the spectral range of other types of semiconductor lasers and cavity designs that are known in the art, as well as in other applications requiring a waveguide-based reflector with precise control of spectral reflectance properties.

In addition to the elements shown in Fig. 1, device 20 may also comprise other components, such as optical bandpass and comb filters, for example as described in the above-mentioned U.S. Patent Application Publication 2025/0096530. These components are omitted here for the sake of simplicity.

### IMPACT OF TUNING MZI REFLECTANCE

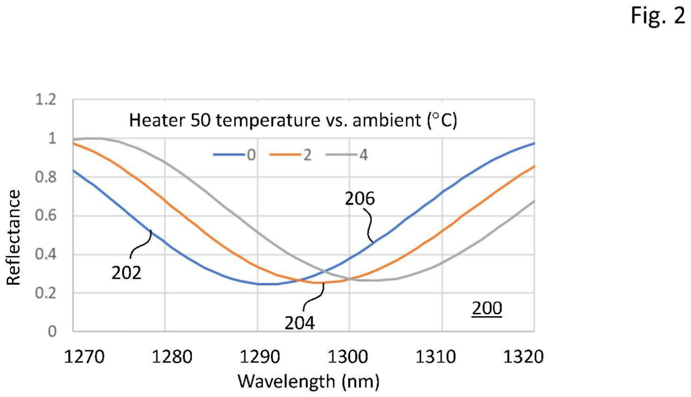

Fig. 2 is a schematic plot 200 of the spectral reflectance of MZI 44 at different temperatures of heater 50, in accordance with an embodiment of the invention. As noted above, the OPD of MZI 44 is greater than 2× lmax.

Plot 200 comprises curves 202, 204 and 206, which respectively correspond to temperatures of heater 50 of 0°C, 2°C and 4°C relative to the ambient temperature of tunable reflector 42. Curves 202-206 maintain their shapes as the temperature changes, while the peak wavelength of the curves shifts with increasing temperature. The curve shape can be made narrower or broader by increasing the temperature sufficiently to change the OPD by a factor of 2λ.

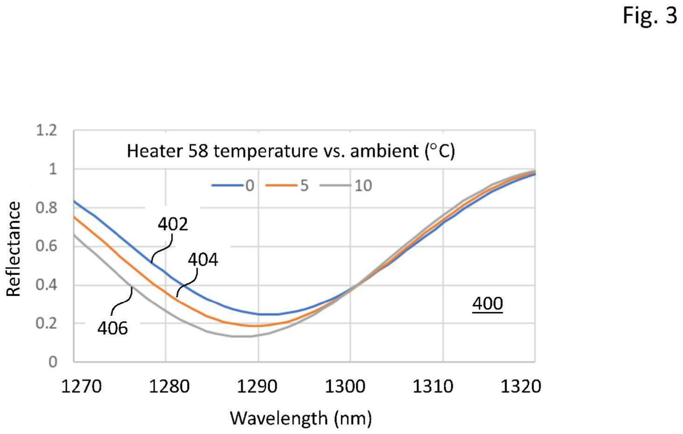

Fig. 3 is a schematic plot 400 of the spectral reflectance of second MZI 52 as a function of a temperature of heater 58, in accordance with an embodiment of the invention. As noted earlier, the OPD of MZI 52 is less than 2× lmin.

Plot 400 comprises curves 402, 404 and 406, which respectively correspond to temperatures of heater 58 of 0°C, 5°C and 10°C relative to the ambient temperature of tunable reflector 42. The reflectance peaks of curves 402-406 shift both down (to a lower reflectance) and to slightly shorter wavelengths with increasing temperature, while the curvature becomes flatter, with broader bandwidth. These changes in curve shape can be combined with the peak wavelength adjustment of Fig. 2 to control the overall spectral reflectance characteristics of tunable reflector 42.

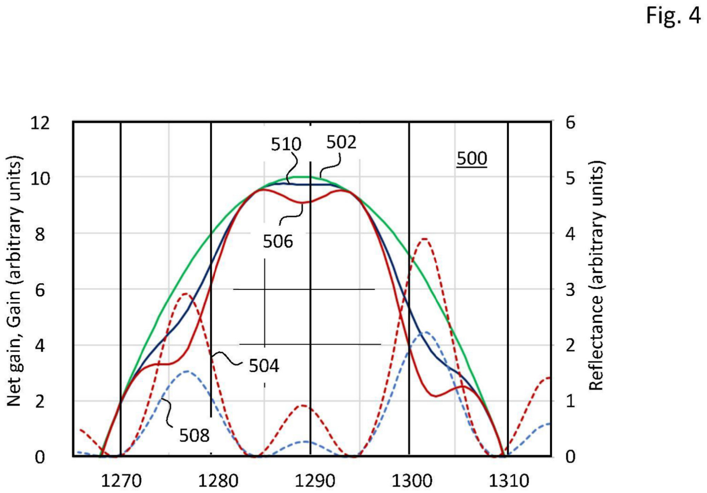

Fig. 4 is a schematic plot 500 of spectral gain compensation of device 20 (Fig. 1) using MZIs 44 and 52, in accordance with an embodiment of the invention. Plot 500 shows the effect of the spectral reflectivity of MZI 52 on the net gain of device 20. The condition for lasing at a given wavelength λ is that gain (λ) ≈ net loss(λ), meaning that the net gain (the difference between gain and net loss) is approximately zero. Because of the reduced reflectance of MZI 52 (illustrated by curves 504 and 508) at the peak of the gain band (illustrated by a curve 502), the net gain has a broad, flat peak with a value of 0.

Curve 502 shows the gain of gain medium 30 as a function of wavelength (λ) in arbitrary units. The reflectance peak of MZI 44 is set to a wavelength near the peak of curve 502. Curve 504 shows the spectral reflectance of MZI 52 at ambient temperature. Due to the relatively high reflectance around the peak wavelength of 1290 nm and concomitant cavity losses, the net gain, as shown by a curve 506, exhibits a dip at this wavelength. Increasing the temperature of second MZI 52 reduces the reflectance of the second MZI at 1290 nm, as shown by a curve 508 and also by curves 404 and 406 in Fig. 4. This reduction lowers the cavity losses and straightens the net gain, as shown by a curve 510.

It will be appreciated that the embodiments described above are cited by way of example, and that the present invention is not limited to what has been particularly shown and described hereinabove. Rather, the scope of the present invention includes both combinations and subcombinations of the various features described hereinabove, as well as variations and modifications thereof which would occur to persons skilled in the art upon reading the foregoing description and which are not disclosed in the prior art.
**The following is a list of further preferred embodiments of the invention:**
Embodiment 1. An optical device for enabling more flexible and precise control of spectral reflectance in a selected wavelength range having a maximal wavelength (λₘₐₓ) and a minimal wavelength (λₘᵢₙ), the device comprising:
   a first Mach-Zehnder interferometer (MZI), comprising first and second legs having a tunable first optical pathlength difference (OPD) greater than 2× λₘₐₓ;
   a second MZI, coupled in series with the first MZI and comprising third and fourth legs having a tunable second OPD less than 2× λₘᵢₙ; and
   an optical coupler configured to direct an input optical signal in the selected wavelength range into the first and second MZIs and to output a reflected optical signal from the first and second MZIs; and
   a controller configured to adjust the first and second tunable OPDs to control the spectral reflectance of the reflected output optical signal.
Embodiment 2. The optical device according to embodiment 1, wherein the first, second, third and fourth legs comprise waveguides.
Embodiment 3. The optical device according to embodiment 2, wherein the waveguides and optical couplers are disposed on a silicon photonic integrated circuit (PIC).
Embodiment 4. The optical device according to embodiment 1, wherein the first and second MZIs comprise respective heaters, and wherein the controller is coupled to drive the respective heaters to adjust the first and second OPDs.
Embodiment 5. The optical device according to embodiment 1, and comprising a termination loop coupled in series with the first and second MZIs.
Embodiment 6. The optical device according to embodiment 1, wherein the controller is configured to tune the first OPD to select a peak wavelength of the spectral reflectance and to tune the second OPD to adjust a curve shape of the spectral reflectance.
Embodiment 7. The optical device according to embodiment 1, wherein the optical coupler comprises a first optical coupler at a first end of the first MZI to split the input optical signal between the first and second legs and to output the reflected optical signal from the first MZI, and
   wherein the optical device further comprises a second optical coupler to couple an input end of the second MZI to a second end of the first MZI, opposite the first end.
Embodiment 8. An optoelectronic device for enabling more flexible and precise control of spectral properties of laser radiation, the device comprising:
   a gain medium and configured to amplify the laser radiation within a gain band between a maximal wavelength (λₘₐₓ) and a minimal wavelength (λₘᵢₙ);
   a laser cavity containing the gain medium and comprising:
      a first reflector disposed on a first side of the gain medium; and
      a second reflector disposed on a second side of the gain medium, opposite the first side, the second reflector comprising:
         a first Mach-Zehnder interferometer (MZI), comprising first and second legs having a tunable first optical pathlength difference (OPD) greater than 2× λₘₐₓ;
         a second MZI, coupled in series with the first MZI and comprising third and fourth legs having a tunable second OPD less than 2× λₘᵢₙ; and
         an optical coupler configured to direct an input optical signal in the selected wavelength range into the first and second MZIs and to output a reflected optical signal from the first and second MZIs; and
   a controller configured to adjust the first and second OPDs to adjust the spectral properties of the laser radiation by controlling a spectral reflectance of the reflected output optical signal from the second reflector relative to the input optical signal.
Embodiment 9. The optoelectronic device according to embodiment 8, wherein the controller is configured to adjust the first and second OPDs so as to reduce a reflectance of the second reflector at a peak of the gain band, thereby broadening a spectrum of the laser radiation emitted from the gain medium through the second reflector.
Embodiment 10. The optoelectronic device according to embodiment 8, wherein the second reflector comprises a termination loop coupled to an output end of the second MZI, opposite the input end.
Embodiment 11. The optoelectronic device according to embodiment 8, wherein the controller is configured to tune the first OPD to select a peak wavelength of the spectral reflectance and to tune the second OPD to adjust a curve shape of the spectral reflectance.
Embodiment 12. The optoelectronic device according to embodiment 8, wherein the optical coupler comprises a first optical coupler at a first end of the first MZI to split the input optical signal between the first and second legs and to output the reflected optical signal from the first MZI, and
   wherein the second reflector further comprises a second optical coupler to couple an input end of the second MZI to a second end of the first MZI, opposite the first end.
Embodiment 13. A method for flexible and precise control of spectral reflectance in a selected wavelength range having a maximal wavelength (λₘₐₓ) and a minimal wavelength (λₘᵢₙ), the method comprising:
   coupling a first Mach-Zehnder interferometer (MZI), comprising first and second legs and having a tunable first optical pathlength difference (OPD) between the first and second legs that is greater than 2× λₘₐₓ, in series with a second MZI, comprising third and fourth legs having a tunable second OPD less than 2× λₘᵢₙ;
   directing an input optical signal in the selected wavelength range into the first and second MZIs;
   outputting a reflected optical signal from the first and second MZIs; and
   adjusting the first and second OPDs to control the spectral reflectance of the reflected optical signal.
Embodiment 14. The method according to embodiment 13, wherein the first, second, third and fourth legs comprise waveguides.
Embodiment 15. The method according to embodiment 14, and comprising forming the waveguides and optical couplers on a silicon photonic integrated circuit (PIC).
Embodiment 16. The method according to embodiment 13, where adjusting the first and second OPDS comprises heating the legs of the first and second OPDs.
Embodiment 17. The method according to embodiment 13, and comprising coupling a termination loop in series with the first and second MZIs.
Embodiment 18. The method according to embodiment 13, wherein adjusting the first and second OPDs comprises tuning the first OPD to select a peak wavelength of the spectral reflectance and tuning the second OPD to adjust a curve shape of the spectral reflectance.
Embodiment 19. The method according to embodiment 13, and comprising coupling the first and second MZIs to create a laser cavity containing a gain medium, wherein adjusting the first and second OPDs comprises tuning an output spectrum emitted from the laser cavity.
Embodiment 20. The method according to embodiment 13, wherein directing the input optical signal comprises splitting the input optical signal at a first end of the first MZI between the first and second legs of the first MZI and coupling a second end of the first MZI, opposite the first end, to the second MZI, and
   wherein outputting the reflected optical signal comprises receiving the reflected optical signal from the first end of the first MZI.

## Claims

1. An optical device for enabling more flexible and precise control of spectral reflectance in a selected wavelength range having a maximal wavelength (λₘₐₓ) and a minimal wavelength (λₘᵢₙ), the device comprising:
a first Mach-Zehnder interferometer (MZI), comprising first and second legs having a tunable first optical pathlength difference (OPD) greater than 2× λₘₐₓ;
a second MZI, coupled in series with the first MZI and comprising third and fourth legs having a tunable second OPD less than 2x λₘᵢₙ; and
an optical coupler configured to direct an input optical signal in the selected wavelength range into the first and second MZIs and to output a reflected optical signal from the first and second MZIs; and
a controller configured to adjust the first and second tunable OPDs to control the spectral reflectance of the reflected output optical signal.

2. The optical device according to claim 1, wherein the first, second, third and fourth legs comprise waveguides.

3. The optical device according to claim 2, wherein the waveguides and optical couplers are disposed on a silicon photonic integrated circuit (PIC).

4. The optical device according to one of claims 1 to 3, wherein the first and second MZIs comprise respective heaters, and wherein the controller is coupled to drive the respective heaters to adjust the first and second OPDs.

5. The optical device according to one of claims 1 to 4, and comprising a termination loop coupled in series with the first and second MZIs.

6. The optical device according to one of claims 1 to 5, wherein the controller is configured to tune the first OPD to select a peak wavelength of the spectral reflectance and to tune the second OPD to adjust a curve shape of the spectral reflectance.

7. The optical device according to one of claims 1 to 6, wherein the optical coupler comprises a first optical coupler at a first end of the first MZI to split the input optical signal between the first and second legs and to output the reflected optical signal from the first MZI, and
wherein the optical device further comprises a second optical coupler to couple an input end of the second MZI to a second end of the first MZI, opposite the first end.

8. An optoelectronic device for enabling more flexible and precise control of spectral properties of laser radiation, the device comprising:
a gain medium and configured to amplify the laser radiation within a gain band between a maximal wavelength (λₘₐₓ) and a minimal wavelength (λₘᵢₙ);
a laser cavity containing the gain medium and comprising:
a first reflector disposed on a first side of the gain medium; and
a second reflector disposed on a second side of the gain medium, opposite the first side, the second reflector comprising:
a first Mach-Zehnder interferometer (MZI), comprising first and second legs having a tunable first optical pathlength difference (OPD) greater than 2× λₘₐₓ;
a second MZI, coupled in series with the first MZI and comprising third and fourth legs having a tunable second OPD less than 2x λₘᵢₙ; and
an optical coupler configured to direct an input optical signal in the selected wavelength range into the first and second MZIs and to output a reflected optical signal from the first and second MZIs; and
a controller configured to adjust the first and second OPDs to adjust the spectral properties of the laser radiation by controlling a spectral reflectance of the reflected output optical signal from the second reflector relative to the input optical signal.

9. The optoelectronic device according to claim 8, wherein the controller is configured to adjust the first and second OPDs so as to reduce a reflectance of the second reflector at a peak of the gain band, thereby broadening a spectrum of the laser radiation emitted from the gain medium through the second reflector.

10. The optoelectronic device according to claim 8 or 9, wherein the second reflector comprises a termination loop coupled to an output end of the second MZI, opposite the input end.

11. The optoelectronic device according to one of claims 8 to 10, wherein the controller is configured to tune the first OPD to select a peak wavelength of the spectral reflectance and to tune the second OPD to adjust a curve shape of the spectral reflectance.

12. The optoelectronic device according to one of claims 8 to 11, wherein the optical coupler comprises a first optical coupler at a first end of the first MZI to split the input optical signal between the first and second legs and to output the reflected optical signal from the first MZI, and
wherein the second reflector further comprises a second optical coupler to couple an input end of the second MZI to a second end of the first MZI, opposite the first end.

13. A method for flexible and precise control of spectral reflectance in a selected wavelength range having a maximal wavelength (λₘₐₓ) and a minimal wavelength (λ₋ₘᵢₙ), the method comprising:
coupling a first Mach-Zehnder interferometer (MZI), comprising first and second legs and having a tunable first optical pathlength difference (OPD) between the first and second legs that is greater than 2× λₘₐₓ, in series with a second MZI, comprising third and fourth legs having a tunable second OPD less than 2× λₘᵢₙ;
directing an input optical signal in the selected wavelength range into the first and second MZIs;
outputting a reflected optical signal from the first and second MZIs; and
adjusting the first and second OPDs to control the spectral reflectance of the reflected optical signal.

14. The method according to claim 13, wherein the first, second, third and fourth legs comprise waveguides, and/or comprising forming the waveguides and optical couplers on a silicon photonic integrated circuit (PIC).

15. The method according to claim 13 or 14, where adjusting the first and second OPDS comprises heating the legs of the first and second OPDs, or
comprising coupling a termination loop in series with the first and second MZIs, or
wherein adjusting the first and second OPDs comprises tuning the first OPD to select a peak wavelength of the spectral reflectance and tuning the second OPD to adjust a curve shape of the spectral reflectance, or
comprising coupling the first and second MZIs to create a laser cavity containing a gain medium, wherein adjusting the first and second OPDs comprises tuning an output spectrum emitted from the laser cavity, or
wherein directing the input optical signal comprises splitting the input optical signal at a first end of the first MZI between the first and second legs of the first MZI and coupling a second end of the first MZI, opposite the first end, to the second MZI, and
wherein outputting the reflected optical signal comprises receiving the reflected optical signal from the first end of the first MZI.
